# EUROPEAN PATENT APPLICATION

(11) **EP 2 611 024 A1**
(43) Date of publication of application: **03.07.2013**
(21) Application number: 11819916.5
(22) Date of filing: 23.08.2011
(51) Int. Cl.: H02N 2/00

(54) **VIBRATION POWER GENERATING ELEMENT AND VIBRATION POWER GENERATING DEVICE USING SAME**

(30) Priority: 25.08.2010 JP 2010188630
(71) Applicant: Panasonic Corporation, Osaka 571-8501 (JP)
(72) Inventor: YAMAUCHI, Norihiro, Kadoma-shi Osaka 571-8686 (JP); OGAWA, Junya, Kadoma-shi Osaka 571-8686 (JP); MATSUSHIMA, Tomoaki, Kadoma-shi Osaka 571-8686 (JP); AIZAWA, Koichi, Kadoma-shi Osaka 571-8686 (JP)
(74) Representative: Appelt, Christian W.
(86) International application number: PCT/JP2011/068941
(87) International publication number: WO 2012/026453

(57) **Abstract**

A vibration power generating element comprises: a substrate provided with a supporting part and a cantilever that is swingably supported by the supporting part; and a power generation part formed at the cantilever and generating AC power in response to swing of the cantilever. The power generation part is provided with first and second piezoelectric converters apposed at a region that overlaps the cantilever at one surface side of the substrate. The vibration power generating element is further provided with a common electrode and individual electrodes. The common electrode is electrically connected to a lower electrode shared by the first and second piezoelectric converters. The individual electrodes are individually connected to upper electrodes of the first and second piezoelectric converters, respectively.

## Description

### TECHNICAL FIELD

The invention relates to a vibration power generating element which converts vibration energy into electrical energy, and a vibration power generating device using the same.

### BACKGROUND ART

As a type of MEMS (Micro Electro Mechanical Systems) devices, there has been recently carried out, at various facilities, research and development regarding a vibration power generating element which converts vibration energy generated by arbitrary vibration, such as vehicle vibration, vibration caused by human motion or the like, into electrical energy.

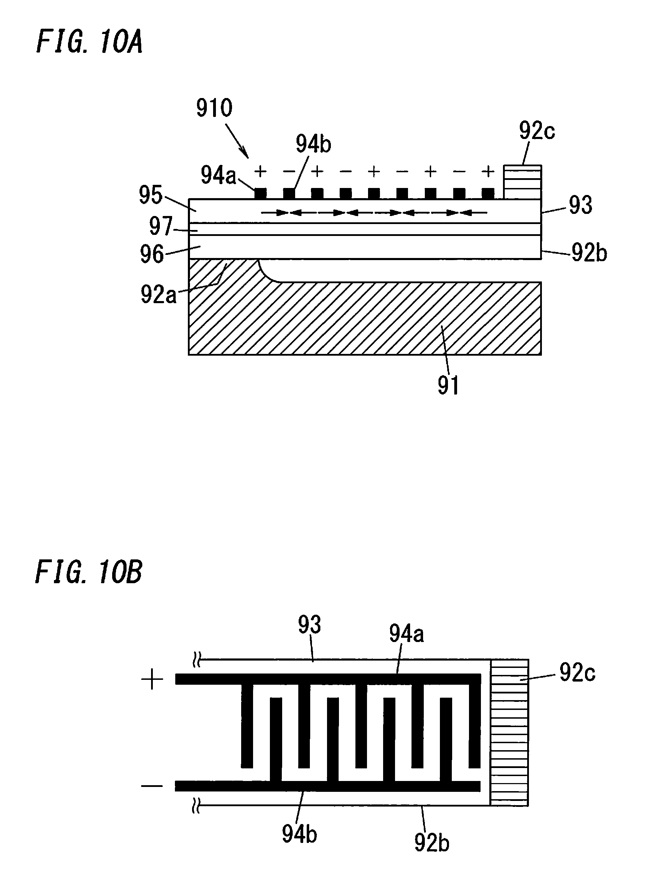

As this type, for example, as shown in Fig. 10A, there has been know a vibration power generating element which includes a substrate 91 made of Si, a cantilever (a deflection part) 92b and a power generation part 93 (e.g., see Y.B.Jeon, et al, "MEMS power generator with transverse mode thin film PZT", Sensors and Actuators A 122, 16-22, 2005). One end of the cantilever 92b is fixed to a supporting part 92a of the substrate 91, and a space is formed between the other end of the cantilever 92b and the substrate 91, and therefore the cantilever 92b is supported swingably. The power generation part 93 is formed on the cantilever 92b and generates AC power in response to swing of the cantilever 92b.

The vibration power generating element 910 shown in Fig. 10A has a configuration that the cantilever 92b includes a thin film 96 made of SiO2 or Si3N4 and a prevention layer 97 (in this case, ZrO2) which is formed on the thin film 96 and prevents diffusion of electric charge generated in the power generation part 93.

The power generation part 93 on the prevention layer 97 includes a piezoelectric layer 95 made of PZT(Pb(Zr,Ti)O3), and a pair of electrodes 94a, 94b made of Pt/Ti and formed at one surface side of the piezoelectric layer 95. The piezoelectric layer 95 is configured to use d33 mode in which a deformation direction is perpendicular to an electric field direction, and then each of the electrodes 94a, 94b is formed into a comb-shape in planar view. The electrodes 94a, 94b are located so as to engage with each other while being separated from each other by a predetermined distance (see Fig. 10B). Further, the vibration power generating element 910 is provided with a weight section 92c on a surface at the other end side of the cantilever 92b, thereby increasing swing of the cantilever 92b.

Then, when the cantilever 92b swings in response to vibration, in the piezoelectric layer 95 of the power generation part 93, polarization is generated along a direction perpendicular to a thickness direction of the piezoelectric layer 95 (see arrowed lines in Fig. 10A). Therefore, in the vibration power generating element 910, the generated electric power can be outputted to an external through the electrodes 94a, 94b.

Here, in the vibration power generating element 910 described in the above-mentioned document, the power generation part 93 generates the power through the swing of the cantilever 92b. For this reason, the electric power outputted through the electrodes 94a, 94b in the vibration power generating element 910 becomes AC power in which reversal of polarity is generated with the swing of the cantilever 92b.

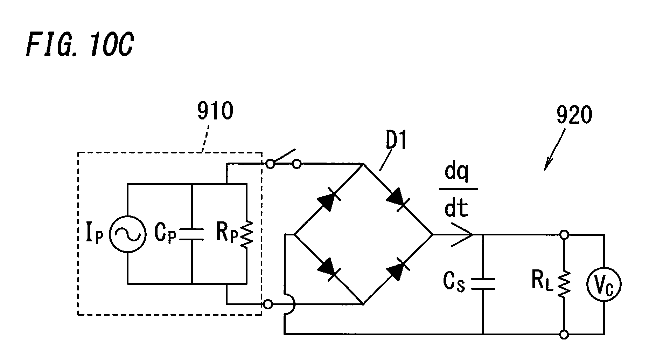

On the other hand, generally, it is assumed that loads connected to the electrodes 94a, 94b in the vibration power generating element 910 are compact electronic components, LSI and the like which require DC power. Therefore, in the above-mentioned document, a vibration power generating device 920, using the vibration power generating element 910, shown in Fig. 10C is configured so as to convert AC power outputted from the vibration power generating element 910 into DC power.

In the vibration power generating device 920, a capacitor Cs is connected in parallel to output terminals of a rectifier D1 that is a single-phase full-wave rectifier circuit (a single-phase bridge rectifier circuit) connected to output terminals of the vibration power generating element 910. A load R_{L} is connected between both ends of the capacitor Cs. Thus, the vibration power generating device 920 can rectify the output of the vibration power generating element 910 to convert AC power into DC power, and can output the DC power into the load R_{L} side connected to the electrodes 94a, 94b. In the vibration power generating device 920 in Fig. 10C, the vibration power generating element 910 is represented by an equivalent circuit, which has an AC source I_{P}, a capacitor C_{P} connected in parallel to the AC source I_{P} and a resistor Rp connected in parallel to the capacitor C_{P}.

However, generally, the generated power from the vibration power generating element 910 is about several microwatts and relatively small. When the rectifier D1 that is a single-phase full-wave rectifier circuit rectifies an electric current outputted from the vibration power generating element 910, voltage drop is generated in p-n junction points of diodes constituting the rectifier D1. Therefore, in the vibration power generating device 920, loss caused by the voltage drop is greatly influenced. Especially, in the vibration power generating device 920 shown in Fig. 10C, when the output of the vibration power generating element 910 is rectified to be converted from AC power into DC power, the electric current from the vibration power generating element 910 is outputted through two diodes in the rectifier D1 that is a single-phase full-wave rectifier circuit. Therefore, the vibration power generating device 920 using the vibration power generating element 910 has a problem that power generation efficiency is reduced.

It is desired that the vibration power generating element 910 has a higher output and a smaller size. Thus, improving the output by simply increasing an area of the piezoelectric layer 95 in the vibration power generating element 910 is undesired. Therefore, the configuration of the vibration power generating element 910 and device 920 is not sufficient, and it is necessary to improve further the element 910 and device 920.

### DISCLOSURE OF THE INVENTION

It is an object of the present invention to provide a vibration power generating element, which can have higher output power and be made smaller, and a vibration power generating device using the same.

A vibration power generating element of the present invention comprises: a substrate provided with a supporting part and a cantilever that is swingably supported by said supporting part; and a power generation part formed at said cantilever and generating AC power in response to swing of said cantilever. Said power generation part is provided with a first piezoelectric converter and a second piezoelectric converter. Said first and second piezoelectric converters are apposed at a region that overlaps said cantilever at one surface side of said substrate. Each of said first and second piezoelectric converters comprises: a lower electrode located at said cantilever side; a piezoelectric layer formed on a surface of said lower electrode, said surface being at the opposite side of said cantilever side through said lower electrode; and an upper electrode formed on a surface of said piezoelectric layer, said surface being at the opposite side of said lower electrode side through said piezoelectric layer. The vibration power generating element is further provided, at said one surface side of said substrate, with a common electrode and individual electrodes. Said common electrode is electrically connected to one of said upper and lower electrodes of said first piezoelectric converter and one of said upper and lower electrodes of said second piezoelectric converter. Said individual electrodes are individually connected to the other of said upper and lower electrodes of said first piezoelectric converter and the other of said upper and lower electrodes of said second piezoelectric converter, respectively. Therefore, the vibration power generating element makes it possible to have higher output power and be made smaller.

In the vibration power generating element, preferably, said upper electrode of said first piezoelectric converter and said upper electrode of said second piezoelectric converter are formed as two electrodes that are spatially separated from each other, and said lower electrode of said first piezoelectric converter and said lower electrode of said second piezoelectric converter are formed as a single shared electrode.

In the vibration power generating element, preferably, said upper electrode of said first piezoelectric converter and said upper electrode of said second piezoelectric converter are formed as a single shared electrode, and said lower electrode of said first piezoelectric converter and said lower electrode of said second piezoelectric converter are formed as two electrodes that are spatially separated from each other.

In the vibration power generating element, preferably, said first and second piezoelectric converters are located at symmetrical positions so that amounts of deformations generated in said first and second piezoelectric converters are equal to each other in a swing direction of said cantilever.

In the vibration power generating element, preferably, said cantilever is formed so as to extend swingably from said supporting part, and said first and second piezoelectric converters are apposed in a direction perpendicular to a extending direction of said cantilever.

In the vibration power generating element, preferably, said piezoelectric layer of said first piezoelectric converter is spatially separated from said piezoelectric layer of said second piezoelectric converter.

A vibration power generating device of the present invention comprises: the above-mentioned vibration power generating element; and a two-phase full-wave rectifier circuit rectifying two-phase AC outputted from said common electrode and said individual electrodes in the vibration power generating element. Therefore, the vibration power generating device makes it possible to have higher output power and be made smaller.

### BRIEF DESCRIPTION OF THE DRAWINGS

Preferred embodiments of the invention will now be described in further details. Other features and advantages of the present invention will become better understood with regard to the following detailed description and accompanying drawings where:
Fig. 1A is a schematic plain view of a vibration power generating element according to First Embodiment of the present invention;
Fig. 1B is a schematic cross-section view taken along line X-X of Fig. 1A;
Fig. 2 is a circuit diagram of a vibration power generating device using the vibration power generating element according to the First Embodiment;
Fig. 3A is a major process drawing for explaining a manufacturing method of the vibration power generating element according to the First Embodiment;
Fig. 3B is a major process drawing for explaining the manufacturing method of the vibration power generating element according to the First Embodiment;
Fig. 3C is a major process drawing for explaining the manufacturing method of the vibration power generating element according to the First Embodiment;
Fig. 4A is a major process drawing for explaining the manufacturing method of the vibration power generating element according to the First Embodiment;
Fig. 4B is a major process drawing for explaining the manufacturing method of the vibration power generating element according to the First Embodiment;
Fig. 4C is a major process drawing for explaining the manufacturing method of the vibration power generating element according to the First Embodiment;
Fig. 5A is a major process drawing for explaining the manufacturing method of the vibration power generating element according to the First Embodiment;
Fig. 5B is a major process drawing for explaining the manufacturing method of the vibration power generating element according to the First Embodiment;
Fig. 5C is a major process drawing for explaining the manufacturing method of the vibration power generating element according to the First Embodiment;
Fig. 6A is a major process drawing for explaining the manufacturing method of the vibration power generating element according to the First Embodiment;
Fig. 6B is a major process drawing for explaining the manufacturing method of the vibration power generating element according to the First Embodiment;
Fig. 7A is a schematic plain view of another vibration power generating element according to the First Embodiment;
Fig. 7B is a schematic cross-section view taken along line X-X of Fig. 7A;
Fig. 8A is a schematic plain view of a vibration power generating element according to Second Embodiment;
Fig. 8B is a schematic cross-section view taken along line X-X of Fig. 8A;
Fig. 9A is a schematic plain view of another vibration power generating element according to the Second Embodiment;
Fig. 9B is a schematic cross-section view taken along line X-X of Fig. 9A;
Fig. 10A is a cross-section view of the conventional vibration power generating element;
Fig. 10B is a plain view showing a major portion of the conventional vibration power generating element; and
Fig. 10C is a circuit diagram of a vibration power generating device using the conventional vibration power generating element.

### BEST MODE FOR CARRYING OUT THE INVENTION

### (First Embodiment)

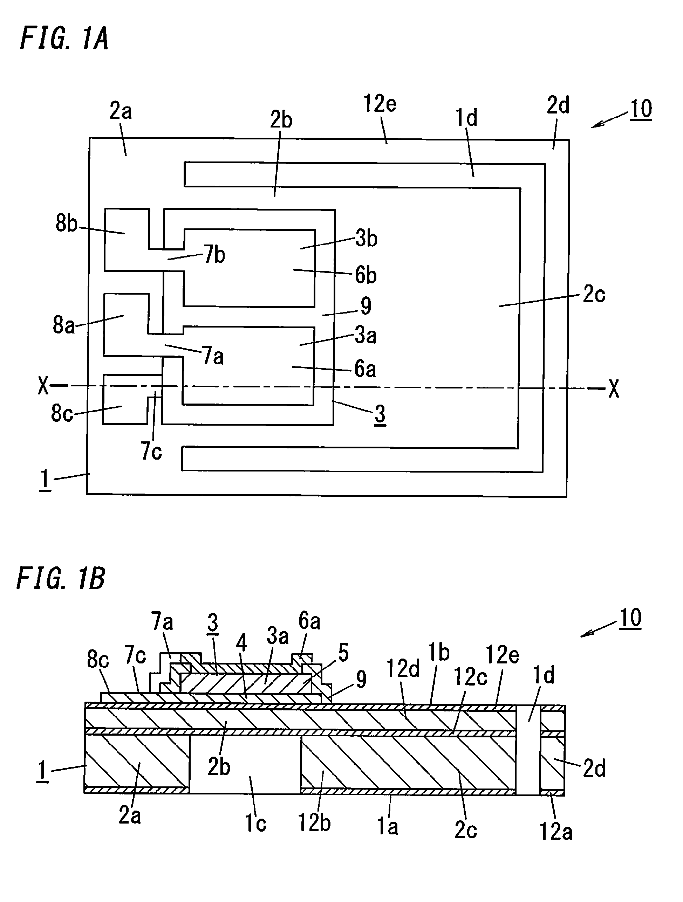

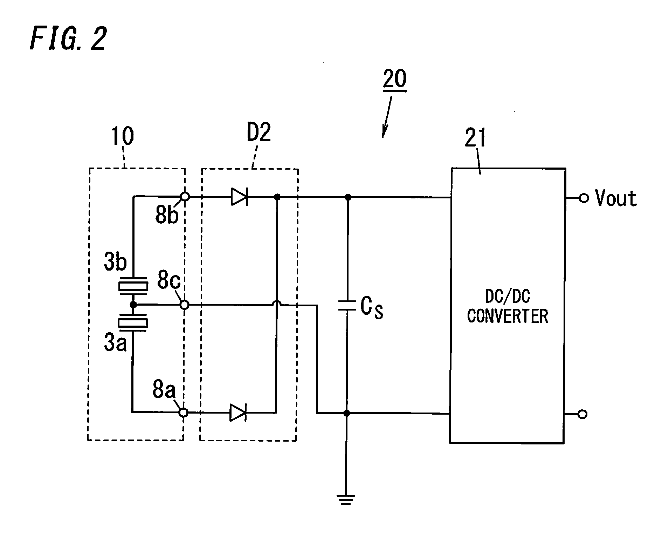

Hereinafter, a vibration power generating element according to the present embodiment is explained referring to Figs. 1A and 1B, and then a vibration power generating device 20 using a vibration power generating element 10 is explained referring to Fig. 2.

As shown in Figs. 1A and 1B, the vibration power generating element 10 according to the present embodiment includes: a substrate 1 provided with a supporting part 2a and a cantilever 2b; and a power generation part 3. The cantilever 2b is located inside of the supporting part 2a and is swingably supported by the supporting part 2a. The power generation part 3 is formed at the cantilever 2b located at one surface 1b side of the substrate 1 and generates AC power in response to swing of the cantilever 2b.

Especially, in the vibration power generating element 10 according to the present embodiment, the power generation part 3 is provided with a first piezoelectric converter 3a and a second piezoelectric converter 3b. The first and second piezoelectric converters 3a, 3b are apposed at a region that overlaps the cantilever 2b at one surface 1b side of the substrate 1. The first and second piezoelectric converters 3a, 3b include: a lower electrode 4 located at the cantilever 2b side; and a piezoelectric layer 5 formed on a surface of the lower electrode 4. Said surface is at the opposite side of the cantilever 2b side through the lower electrode 4. The first and second piezoelectric converters 3a, 3b further include upper electrodes 6a, 6b formed on a surface of the piezoelectric layer 5, respectively. Said surface is at the opposite side of the lower electrode 4 side through the piezoelectric layer 5.

The vibration power generating element 10 according to the present embodiment is further provided, at one surface 1b side of the substrate 1, with a common electrode 8c and individual electrodes 8a, 8b. The common electrode 8c is a pad for a lower electrode, and is electrically connected to the single shared lower electrode 4 shared by the first and second piezoelectric converters 3a, 3b. The individual electrodes 8a, 8b are pads for upper electrodes, and are individually connected to the upper electrode 6a of the first piezoelectric converter 3a and the upper electrode 6b of the second piezoelectric converter 3b, respectively.

At one surface 1b side of the substrate 1, the individual electrodes 8a, 8b are formed at regions corresponding to the supporting part 2a, and are electrically connected to the upper electrodes 6a, 6b, through connecting parts 7a, 7b, respectively. Also, at one surface 1b side of the substrate 1, the common electrode 8c is formed at a region corresponding to the supporting part 2a, and is electrically connected to the lower electrode 4 through a connecting part 7c. In planar view, the substrate 1 is provided with a weight section 2c through the cantilever 2b. The weight section 2c is located at the side facing the supporting part 2a. Further, the weight section 2c is located inside of a C-shaped frame 2d, which extends from the supporting part 2a via a through-hole 1d, so as to be surrounded by the frame 2d.

The power generation part 3 is designed so that in planar view the size of the piezoelectric layer 5 is smaller than that of the lower electrode 4. Further, the power generation part 3 is designed so that in planar view the total size of the upper electrodes 6a, 6b is smaller than the size of the piezoelectric layer 5.

At one surface 1b side of the substrate 1, the power generation part 3 is located so as to correspond to a hollow 1c provided at the other side 1a side of the substrate 1. Here, in planar view of the power generation part 3, the piezoelectric layer 5 is positioned inside of a peripheral line of the lower electrode 4, and the upper electrodes 6a, 6b are apposed inside of a peripheral line of the piezoelectric layer 5 while having contact with the piezoelectric layer 5.

Further, in the power generation part 3, an insulation layer 9 is formed so as to cover peripheries of the lower electrode 4 and the piezoelectric layer 5, thereby preventing a short circuit between the upper electrodes 6a, 6b side and the lower electrode 4 side. In planar view, the insulation layer 9 defines an area where each of the upper electrodes 6a, 6b has contact with the piezoelectric layer 5 at one surface 1b side of the substrate 1. That is, the insulation layer 9 in the planar view is formed into a frame shape along peripheries of the upper electrodes 6a, 6b. Therefore, the insulation layer 9 can prevent a short circuit between the lower electrode 4 and the connecting parts 7a, 7b which are electrically connected to the upper electrodes 6a, 6b, respectively.

Further, in the vibration power generating element 10, the insulation layer 9 is made of a silicon oxide film, but is not limited to it. The insulation layer 9 may be made of a silicon nitride film. Further, the insulation layer 9 may be formed of not a single layer film but a multiple layer. In the vibration power generating element 10 according to the present embodiment, because the insulation layer 9 formed at the upper side of the cantilever 2b is made of the silicon oxide film or the silicon nitride film, the insulation performance and heat resistance performance can be improved compared with the case where the insulation layer 9 is made of resist.

Insulation films 12e, 12a are made of silicon oxide films, and are formed at one surface 1b side and the other surface 1a side of the substrate 1, respectively. Therefore, the power generation part 3 is electrically insulated from the substrate 1 by the insulation film 12e formed at one surface 1b side.

In the vibration power generating element 10, the power generation part 3 is provided with: the first piezoelectric converter 3a including the lower electrode 4, piezoelectric layer 5 and upper electrode 6a; and the second piezoelectric converter 3b including the lower electrode 4, piezoelectric layer 5 and upper electrode 6b. As a result, the first and second piezoelectric converters 3a, 3b are subjected to stress in response to vibration of the cantilever 2b, and generate electric power separately. That is, in the first piezoelectric converters 3a, electric charge is deflected in a region of the piezoelectric layer 5 positioned between the lower electrode 4 and upper electrode 6a, and therefore, AC power is generated. At the same time, in the second piezoelectric converters 3b, electric charge is deflected in a region of the piezoelectric layer 5 positioned between the lower electrode 4 and upper electrode 6b, and therefore, AC power is generated.

In the vibration power generating element 10, PZT is adopted as a piezoelectric material of the piezoelectric layer 5 in order to use d31 mode in which a deformation direction is parallel to an electric field direction. However, the piezoelectric material is not limited to PZT. For example, PZT-PMN(:Pb(Mn,Nb)O3), PLZT((Pb,La)(Zr,Ti)O3), SBT(SrBi2Ta2O9), or the like may be adopted.

Further, in the vibration power generating element 10, the substrate 1 is formed by using a SOI (Silicon on Insulator) substrate having the configuration that an embedded oxide film 12c made of a silicon oxide film is sandwiched between a single-crystal silicon substrate 12b and a single-crystal silicon layer (an active layer) 12d. In the SOI substrate, a surface of the silicon layer 12d is formed with a (100) face.

Further, in the vibration power generating element 10, because the SOI substrate is adopted as the substrate 1, the embedded oxide film 12c in the SOI substrate can be used as an etching stopper layer when the cantilever 2b is formed, at the time of manufacturing as described below. Therefore, the vibration power generating element 10 can enhance accuracy of the thickness of the cantilever 2b, and further can improve the credibility and reduce the cost. The substrate 1 is not limited to the SOI substrate. For example, a single-crystal silicon substrate or the like may be adopted as the substrate 1.

Further, in the vibration power generating element 10, the lower electrode 4 is made of a Pt film, and each of the upper electrodes 6a, 6b is made of a laminated film including a Ti film and an Au film. However, these materials and layered structure of the lower electrode 4 and upper electrodes 6a, 6b are not limited especially. Each of the lower electrode 4 and upper electrodes 6a, 6b may have a single-layer structure, or a multilayer structure. As the electrode material of the lower electrode 4, for example, Au, Al, Ir, In or the like may be adopted. As the materials of the upper electrodes 6a, 6b, for example, Mo, Al, Pt or the like may be adopted.

In the vibration power generating element 10, the lower electrode 4 is set to have a thickness of 100 [nm], the piezoelectric layer 5 is set to have a thickness of 600 [nm], and each of the upper electrodes 6a, 6b is set to have a thickness of 100 [nm]. However, these thicknesses of the lower electrode 4, piezoelectric layer 5 and upper electrodes 6a, 6b are not limited especially, and can be set as someone thinks fit.

In the vibration power generating element 10, the cantilever 2b is formed into a rectangle in planar view. However, the shape of the cantilever 2b is not limited to the rectangle. For example, the cantilever 2b may be formed into a trapezoid in the planar view so that a width at a position of the cantilever 2b decreases gradually as the position is separated from the supporting part 2a and comes close to the weight section 2c.

In the vibration power generating element 10, the piezoelectric layer 5 is located inside of the peripheral line of the lower electrode 4, in planar view. For this reason, the vibration power generating element 10 can reduce a height of a part being a base under the connecting parts 7a, 7b, compared with the case where the lower electrode 4 and piezoelectric layer 5 have substantively the same planar size.

Therefore, the vibration power generating element 10 can reduce a risk of disconnection generated in the connecting parts 7a, 7b with the swing of the cantilever 2b, and the credibility can be further improved.

In the vibration power generating element 10, the insulation layer 9 prevents a short circuit between the upper electrodes 6a, 6b and the lower electrode 4. In this case, the insulation layer 9 may be formed so as to extend to the supporting part 2a, at one surface 1b side of the substrate 1. That is, the entire areas of the connecting parts 7a, 7b may be formed on the insulation layer 9, in the case where the connecting parts 7a, 7b are located between the upper electrodes 6a, 6b and the individual electrodes 8a, 8b electrically connected to the upper electrodes 6a, 6b, respectively. Then, the individual electrodes 8a, 8b may be formed on a flat area of the insulation layer 9 (its appearance is not shown). Therefore, the vibration power generating element 10 can reduce the height of the part being the base under the connecting parts 7a, 7b, and can reduce further a risk of disconnection generated in the connecting parts 7a, 7b through which the lower electrode 4 is electrically connected to the individual electrodes 8a, 8b, while the piezoelectric layer 5 has a large film thickness.

In the vibration power generating element 10, the first and second piezoelectric converters 3a, 3b are located at substantively symmetrical positions in planar view so that amounts of deformations generated in the first and second piezoelectric converters 3a, 3b are equal to each other in a swing direction of the cantilever 2b. Therefore, the vibration power generating element 10 enables the electric powers outputted from the first and second piezoelectric converters 3a, 3b to be equal to each other. The first and second piezoelectric converters 3a, 3b generate substantively the same amount of electric charge in response to the swing of the cantilever 2b. Therefore, a decrease in the power generation efficiency can be suppressed.

Especially, in planar view of the vibration power generating element 10, the first and second piezoelectric converters 3a, 3b are apposed in a direction perpendicular to a extending direction (the right direction in Fig. 1A) in which the cantilever 2b extends from the supporting part 2a. Therefore, the decrease in the power generation efficiency can be suppressed more effectively.

In the vibration power generating element 10, the electric power generated in the first piezoelectric converter 3a can be outputted using the common electrode 8c and the individual electrodes 8a. Similarly, the electric power generated in the second piezoelectric converter 3b can be outputted using the common electrode 8c and the individual electrodes 8b.

In this case, as shown in Fig. 2, the vibration power generating element 10 according to the present embodiment is connected to a rectifier D2 that is a two-phase full-wave rectifier circuit rectifying two-phase AC outputted from the common electrode 8c and the individual electrodes 8a, 8b in the vibration power generating element 10, thereby the vibration power generating device 20 being configured. Then, in the vibration power generating device 20, a capacitor Cs is connected between both ends of the rectifier D2. In the vibration power generating device 20, depending on a load (not shown) connected to the vibration power generating device 20, a DC/DC converter 21 is provided between the capacitor Cs and the load, and appropriately boosts or steps down a voltage supplied to the load side.

Then, the vibration power generating device 20 using the vibration power generating element 10 is different from the above-mentioned vibration power generating device 920 shown in Fig. 10C in that an electric current is outputted from the vibration power generating element 10 via one diode included in the rectifier D2 when output of the vibration power generating element 10 is rectified and converted from AC power to DC power. As a result, the vibration power generating device 20 can reduce loss produced in the diode included in the rectifier, and can improve the power generation efficiency, compared with the vibration power generating device 920 shown in Fig. 10C.

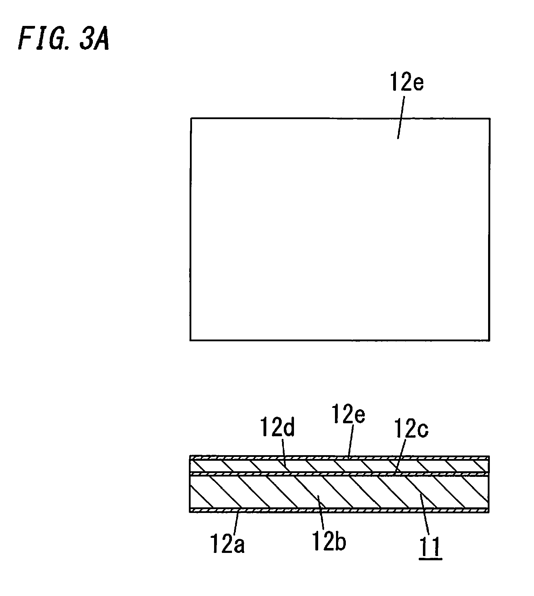

A manufacturing method of the vibration power generating element 10 according to the present embodiment is explained below referring to Figs. 3A to 3C, 4A to 4C, 5A to 5C, 6A, and 6B. In the manufacturing process shown in each Figure, a plane view is located at the upper side, and a schematic cross-section view showing a major portion is located at the lower side.

First, a forming process for insulation film is performed (see Fig. 3A). In this process, the insulation films 12e, 12a made of silicon oxide films are formed, by the thermal oxidation method or the like, at one surface side and the other surface side of an element formation substrate 11 that is made of the SOI substrate and becomes the substrate 1, respectively. For this reason, the substrate 1 formed by using the element formation substrate 11 is provided with the insulation film 12e at one surface 1b side, and with the insulation film 12a in the other surface 1a. The element formation substrate 11 made of the SOI substrate has the configuration that the embedded oxide film 12c made of a silicon oxide film is sandwiched between the single-crystal silicon substrate 12b and single-crystal silicon layer 12d.

Then, a forming process for first metal film is performed. In this process, a first metal film 24 made of a Pt layer is formed, by the sputtering method, chemical vapor deposition method (CVD method) or the like, on the entire surface of one surface side of the element formation substrate 11. The first metal film 24 becomes the basis for the lower electrode 4, connecting part 7c and common electrode 8c. However, the first metal film 24 is not limited to a Pt film. For example, the first metal film 24 may be an Al film or an Al-Si film, or may include: an Au film; and a Ti film that is located between the Au film and the insulation film 12e and is used as an adherent film for improving adhesion. In this case, the material of the adherent film (not shown) is not limited to Ti. For example, Cr, Nb, Zr, TiN, TaN or the like may be used as the material.

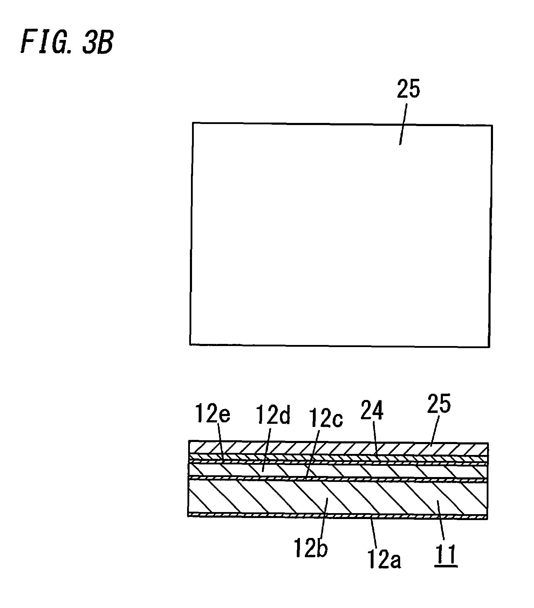

Next, a forming process for piezoelectric film is performed (see Fig. 3B). In this process, a piezoelectric film 25 (for example, a PZT film) is formed, by the sputtering method, CVD method, sol-gel method, transfer method or the like, on the entire surface of one surface side of the element formation substrate 11. The piezoelectric film 25 becomes the basis for the piezoelectric layer 5 made of a piezoelectric material (for example, PZT or the like).

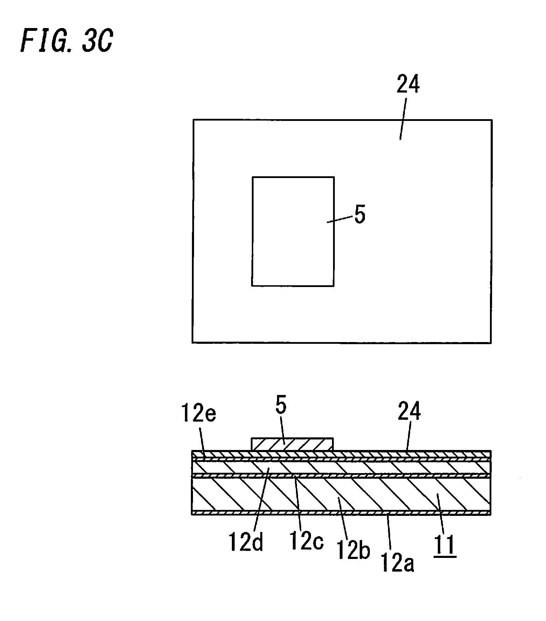

Next, after the forming process for piezoelectric film, a patterning process for piezoelectric film is performed (see Fig. 3C). In this process, in order to form the piezoelectric film 25 into a predetermined shape, the patterning of the piezoelectric film 25 is performed by using the photolithography technique and etching technique. Therefore, the piezoelectric layer 5 is formed of a part of the piezoelectric film 25.

In the vibration power generating element 10, the piezoelectric layer 5 is formed directly on the lower electrode 4. However, a seed layer that becomes a base for depositing the piezoelectric layer 5 may be located between the piezoelectric layer 5 and lower electrode 4, thereby improving the crystallinity of the piezoelectric layer 5. As a material of the seed layer, for example, PLT((Pb,La)TiO3), PTO(PbTiO3), SRO(SrRuO3) or the like is cited and is a type of conductive oxide materials.

The patterning process for piezoelectric film can be omitted, if the piezoelectric layer 5 is formed into the predetermined shape by the transfer method. In this case, for example, a piezoelectric film made of a ferroelectric thin film is previously formed, by the sputtering method, CVD method, sol-gel method or the like, on one surface of a piezoelectric film formation substrate (not shown). Next, in the state where the piezoelectric film in the piezoelectric film formation substrate is located so as to be faced with the metal film that becomes the basis for the lower electrode 4 formed on the element formation substrate 11 by the forming process for first metal film, a laser beam is emitted from the other surface side of the piezoelectric film formation substrate with translucency. The laser beam is emitted so as to be absorbed into an interface between the piezoelectric film and the piezoelectric film formation substrate. Therefore, a part of the piezoelectric film is detached from the piezoelectric film formation substrate. Then, the detached part of the piezoelectric film is transferred into the side of the metal film that becomes the basis for the lower electrode 4 of the element formation substrate 11, and becomes the piezoelectric layer 5. Through controlling an area irradiated with the laser beam, the piezoelectric film can be transferred into the metal film that becomes the lower electrode 4 later, at a smaller size than the outer shape of the lower electrode 4, in planar view.

Preferably, a difference between lattice constants of the piezoelectric film formation substrate and the piezoelectric film that becomes the basis for the piezoelectric layer 5 is smaller than that of the substrate 1 and the piezoelectric film, and then the piezoelectric film formation substrate has better lattice matching than the substrate 1, with respect to the piezoelectric film. For example, when PZT is used as the material of the piezoelectric film, a single-crystal MgO substrate, a single-crystal STO(SrTiO3) substrate or the like can be used as the piezoelectric film formation substrate. The laser beam used for transferring the part of the piezoelectric film from the piezoelectric film formation substrate can be emitted from for example a KrF excimer laser. Furthermore, a seed layer, such as PLT, PTO or SRO, may be located between the piezoelectric film formation substrate and the piezoelectric film, in order to control the crystalline orientation of the piezoelectric film. The seed layer can be used as a sacrifice layer into which the laser beam is absorbed and which is removed, when the piezoelectric film is transferred in the case where a part of the piezoelectric film is detached. When attached to the element formation substrate 11 side with the transfer of the piezoelectric film, an unwanted broken piece of the piezoelectric film formation substrate may be removed appropriately by etchant.

The manufacturing time of the vibration power generating element 10 can be shortened by using the above-mentioned transfer method in which the separately formed piezoelectric film is transferred and the piezoelectric layer is formed. That is, the forming process for piezoelectric film which takes so long to form the piezoelectric film can be separately performed in parallel with respect to the metal film and the piezoelectric layer, compared with the manufacturing method of the vibration power generating element 10 in which the piezoelectric layer 5 is deposited after the formation of the metal film.

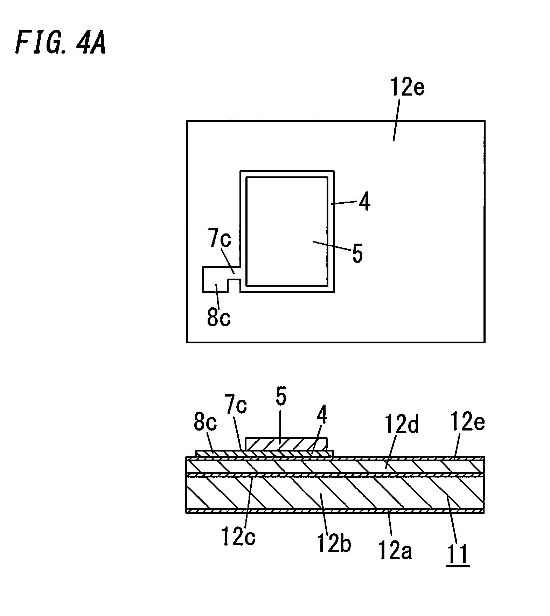

Next, after the formation of the piezoelectric layer 5 shown in Fig. 3C, a patterning process for metal film is performed (see Fig. 4A). In this process, in order to form the first metal film 24 into a predetermined shape, the patterning of the first metal film 24 is performed by using the photolithography technique and etching technique. Therefore, the lower electrode 4, connecting part 7c and common electrode 8c are formed of parts of the first metal film 24. In the manufacturing method of the vibration power generating element 10, the lower electrode 4, connecting part 7c and common electrode 8c are formed at the same time. Here, all of the lower electrode 4, connecting part 7c and common electrode 8c are formed at the same time, by performing the patterning of the first metal film 24, in the patterning process for metal film, but instead only the lower electrode 4 may be formed.

In this case, after the formation of the lower electrode 4, a forming process for connection may be additionally provided to form the connecting part 7c and common electrode 8c. Similarly, a forming process for the connecting part 7c and a forming process for the common electrode 8c may be provided separately. When etching of the first metal film 24 is performed, the reactive ion etching (RIE) method, ion milling method or the like can be adopted appropriately for example.

In the manufacturing method of the vibration power generating element 10, the single lower electrode 4 shared by the first and second piezoelectric converter 3a, 3b is formed by the processing of the first metal film 24, in the patterning process for metal film shown in Fig. 4A.

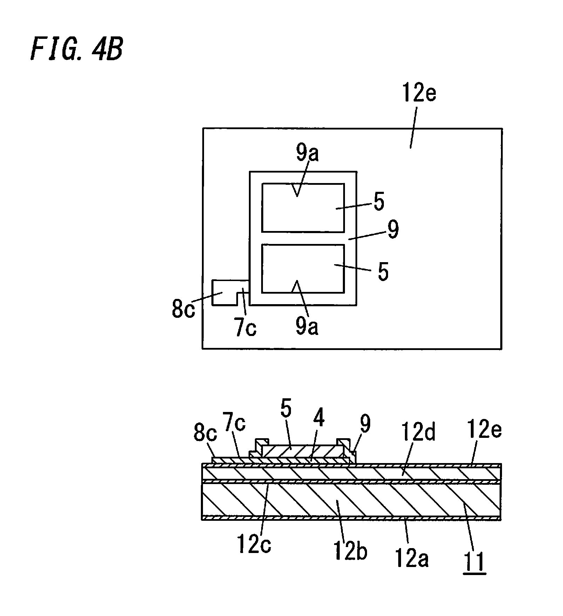

After the lower electrode 4, connecting part 7c and common electrode 8c are formed by the patterning process for metal film, a forming process for insulation layer is performed (see Fig. 4B). In this process, the insulation layer 9 is formed at above-mentioned one surface side of the element formation substrate 11. In this process, after a resist film is applied to the above-mentioned one surface side of the element formation substrate 11 on which the piezoelectric layer 5 is formed, the patterning of the resist film is performed by using the photolithography technique. Then, an insulation film is deposited on the entire surface of the above-mentioned one surface side of the element formation substrate 11 by CVD method or the like, and the insulation layer 9 is then formed by using lift-off technique for detaching the resist film. In the forming process for insulation layer, the method for forming the insulation layer 9 is not limited to only the lift-off technique. The patterning may be performed by using the photolithography technique and etching technique. Through the formation of the insulation layer 9, two opening parts 9a that have substantively the same rectangle in planar view are formed and apposed at the above-mentioned one surface side of the element formation substrate 11 (see the upper side in Fig. 4B).

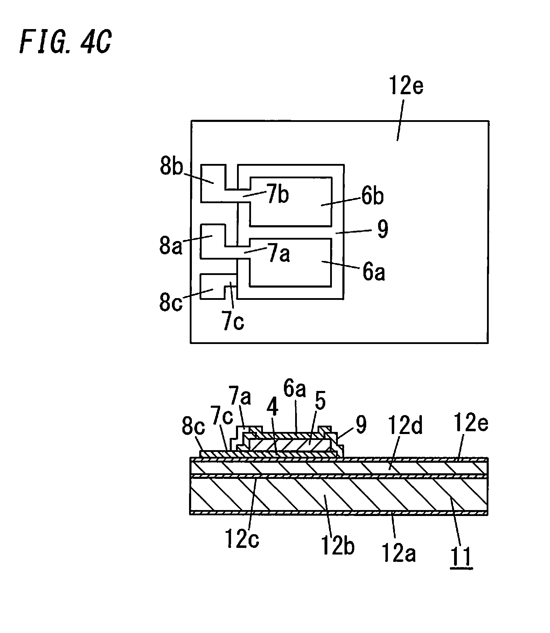

Next, in a forming process for the upper electrodes 6a, 6b, after a resist film is applied to the above-mentioned one surface side of the element formation substrate 11 on which the insulation layer 9 has been formed, the patterning of the resist film is performed by the photolithography technique. Then, a metal film is deposited, and the lift-off technique for detaching the resist film is performed. Therefore, the upper electrodes 6a, 6b, connecting parts 7a, 7b, and individual electrodes 8a, 8b are formed. In this way, the forming process for upper electrode is performed (see Fig. 4C). The upper electrodes 6a, 6b may be formed together with the connecting parts 7a, 7b and individual electrodes 8a, 8b simultaneously, by the forming process for upper electrode using the thin film coating technology, such as the electron beam (EB) evaporation method, sputtering method or CVD method, the photolithography technique, and the etching technique. In the manufacturing method of the vibration power generating element 10, the upper electrodes 6a, 6b, connecting parts 7a, 7b and individual electrodes 8a, 8b are formed simultaneously in the forming process for upper electrode, but the forming process is not limited to such a way. The forming process for upper electrode and a forming process for connection may be performed separately. Further, in regard to the forming process for connection, a forming process for the connecting parts 7a, 7b and a forming process for the individual electrodes 8a, 8b may be performed separately.

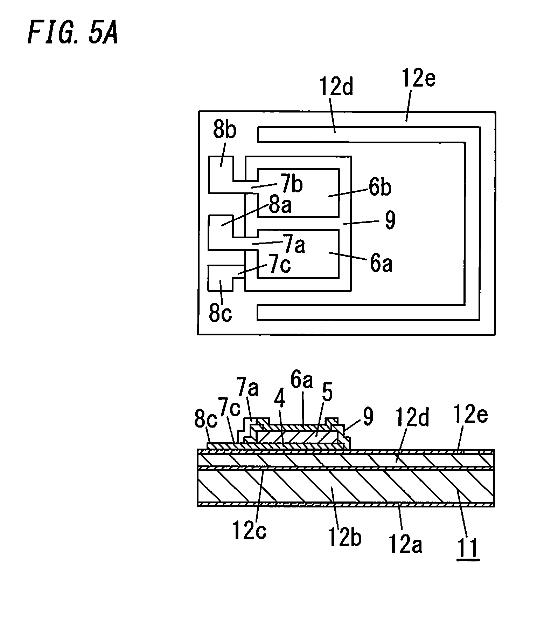

A forming process for element formation substrate is then performed. Here, the processing of the element formation substrate 11 is performed by using the photolithography technique, etching technique and the like, and therefore the substrate 1 including the supporting part 2a and cantilever 2b is formed. Etching of the insulation film 12e other than parts that become the supporting part 2a, cantilever 2b, and weight section 2c is performed with BHF or the like, from the above-mentioned one surface side of the element formation substrate 11, by using the photolithography technique, etching technique and the like. In this way, a process for removing surface insulation film is performed to expose a part of the silicon layer 12d of the element formation substrate 11 (see Fig. 5A).

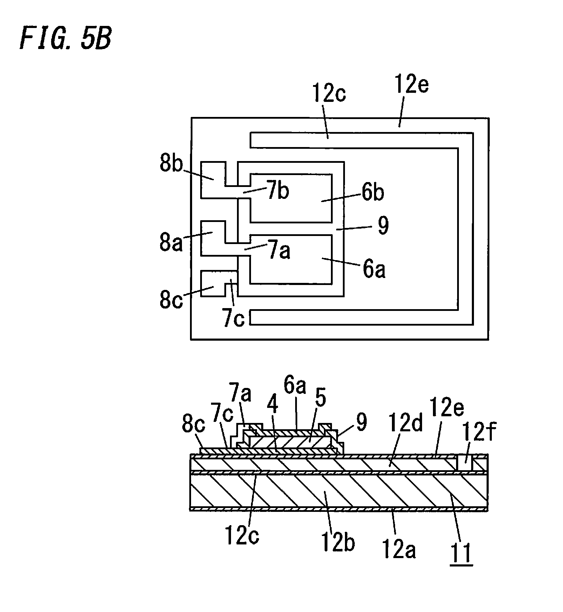

Then, the part of the silicon layer 12d exposed by removing a part of the insulation film 12e is removed by RIE method, at the above-mentioned one surface side of the element formation substrate 11. In this way, a forming process for surface groove is performed to expose a part of the embedded oxide film 12c and form a surface groove 12f that becomes a part of the through-hole 1d (see Fig. 5B).

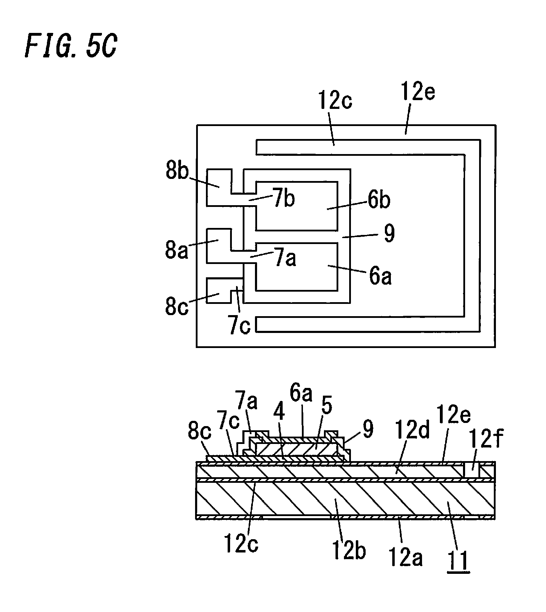

Then, etching of the insulation film 12a other than parts that become the supporting part 2a, cantilever 2b, and weight section 2c is performed with BHF or the like, from the other surface side of the element formation substrate 11, by using the photolithography technique, etching technique and the like. In this way, parts of the insulation film 12a are removed and the single-crystal silicon substrate 12b is exposed (see Fig. 5C).

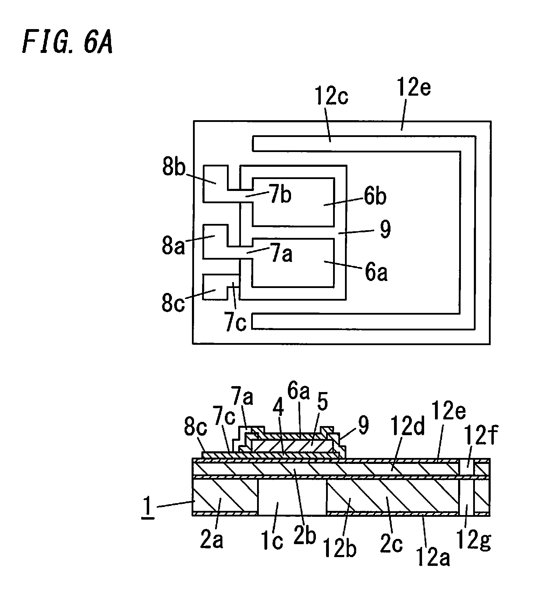

After removing of the parts of the insulation film 12a, etching of parts of the single-crystal silicon substrate 12b exposed by the removing is performed from the other surface side of the element formation substrate 11 to a predetermined depth that reaches the embedded oxide film 12c, by Deep-RIE method. In this way, a forming process for rear surface groove is performed (see Fig. 6A). That is, the parts of the embedded oxide film 12c are exposed at the other surface side of the element formation substrate 11, and thus a rear surface groove that becomes a part of the through-hole 1d is formed. In the forming process for rear surface groove, the hollow 1c is formed at the other surface side of the element formation substrate 11, at the same time as the formation of the rear surface groove.

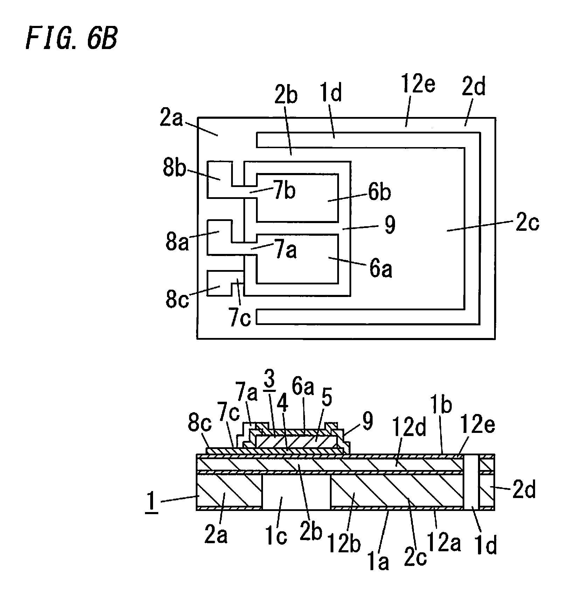

Then, a process for etching oxide film is performed (see Fig. 6B). In this process, unwanted parts of the embedded oxide film 12c are removed by etching using RIE method, and the through-hole 1d is formed so that the surface groove 12f is communicated with the rear surface groove 12g. Therefore, in the manufacturing of the vibration power generating element 10, the cantilever 2b can be formed together with the weight section 2c. In the vibration power generating element 10, the weight section 2c is provided through the cantilever 2b by forming the through-hole 1d, and is located at the side facing the supporting part 2a. Further, the weight section 2c is located inside of the C-shaped frame 2d, which extends from the supporting part 2a via the through-hole 1d, so as to be surrounded by the frame 2d.

Because the vibration power generating element 10 includes the weight section 2c provided through the cantilever 2b and located at the side facing the supporting part 2a, more electrical energy can be generated, compared with a vibration power generating element without the weight section 2c. However, the vibration power generating element 10 has only to include the cantilever 2b swingably supported by the supporting part 2a, and forming of the weight section 2c and frame 2d is not indispensable. As a result, if the vibration power generating element 10 includes the cantilever 2b, the process for etching oxide film in which the through-hole 1d is formed can be also omitted. Further, the manufacturing may be performed at the wafer level until the forming process for element formation substrate is completed, and after that, a dicing process may be performed to divide to individual vibration power generating elements 10. In this way, a plurality of vibration power generating elements 10 can be formed and be mass-produced.

The vibration power generating element 10 shown in Figs. 1A and 1B is basically provided with the substrate 1 and the power generation part 3. However, the vibration power generating element 10 may further include: a first cover substrate (not shown) which is secured to the supporting part 2a and the frame 2d at one surface 1b side of the substrate 1; and a second cover substrate (not shown) which is secured to the supporting part 2a and the frame 2d at the other surface 1a side of the substrate 1.

For example, a glass substrate or a silicon substrate provided with a recess may be adopted as the first cover substrate. In this case, the recess is provided to form, at one surface 1b of the substrate 1 side, a space where the cantilever 2b and the weight section 2c can swing between the substrate 1 and the first cover substrate.

Further, the first cover substrate may be provided appropriately with electrodes for communication, which are bonded to the common electrode 8c and individual electrodes 8a, 8b of the substrate 1 and are capable of output to an external, respectively.

Then, a glass substrate or a silicon substrate provided with a recess may be adopted as the second cover substrate. In this case, the recess is provided to form, at the other surface 1a of the substrate 1 side, a space where the cantilever 2b and the weight section 2c can swing between the substrate 1 and the second cover substrate. Here, the first and second cover substrates are bonded to the substrate 1 by a room temperature bonding method, a resin bonding method using epoxy resin or the like, an anodic bonding method, or the like.

In the manufacturing of the vibration power generating element 10 provided with the first and second cover substrates, a cover bonding process should be performed to bond each cover substrate, after the formation of the substrate 1. In this case, the manufacturing should be performed at the wafer level until the cover bonding process is completed, and after that, a dicing process should be performed to divide to individual vibration power generating elements 10.

In the vibration power generating element 10 explained above, the polling treatment of the piezoelectric layer 5 using a ferroelectric thin film can be performed by applying high electrical field between the lower electrode 4 and the upper electrodes 6a, 6b. In the vibration power generating element 10, even if the piezoelectric layer 5 using the ferroelectric thin film has various directions of polarization, the various directions of polarization can be made so as to face the same direction by the polling treatment. Similarly, in the vibration power generating element 10, even if being different from the swing direction of the cantilever 2b, the directions of polarization in the piezoelectric layer 5 can be made so as to face the same direction as the swing direction of the cantilever 2b by the polling treatment. Therefore, the vibration power generating element 10 can inhibit a decrease in the power generation efficiency caused by the various directions of polarization in the piezoelectric layer 5, and a difference between the direction of polarization in the piezoelectric layer 5 and the swing direction of the cantilever 2b.

Especially, in the vibration power generating element 10, the polling treatment of the piezoelectric layer 5 using a ferroelectric thin film can be performed by applying high electrical field between the lower electrode 4 and the upper electrode 6a, and applying high electrical field between the lower electrode 4 and the upper electrode 6b, at the same time. Therefore, this polling treatment allows performing simultaneously processes for making the direction of polarization in the first piezoelectric converter 3a and the direction of polarization in the second piezoelectric converter 3b so as to face the same direction with respect to a thickness direction of the power generation part 3.

In the vibration power generating element 10 formed in this way, the first and second piezoelectric converters 3a, 3b are apposed at a region that overlaps the cantilever 2b at one surface 1b side of the substrate 1. For this reason, a piezoelectric layer of the first piezoelectric converter 3a and a piezoelectric layer of the second piezoelectric converter 3b can be formed simultaneously as the shared piezoelectric layer 5. Therefore, the vibration power generating element 10 can shorten the deposition time of the piezoelectric layer 5, compared with a vibration power generating element 10 in which the piezoelectric layers of the first and second piezoelectric converters 3a, 3b are formed in separate process.

The vibration power generating element 10 includes the first and second piezoelectric converters 3a, 3b apposed at a region that overlaps the cantilever 2b at one surface 1b side of the substrate 1, and further includes: the common electrode 8c electrically connected to the single shared lower electrode 4 shared by the first and second piezoelectric converters 3a, 3b; and the individual electrodes 8a, 8b individually connected to the upper electrode 6a of the first piezoelectric converter 3a and the upper electrode 6b of the second piezoelectric converter 3b, respectively. Therefore, the vibration power generating element 10 can have higher output power and be made smaller.

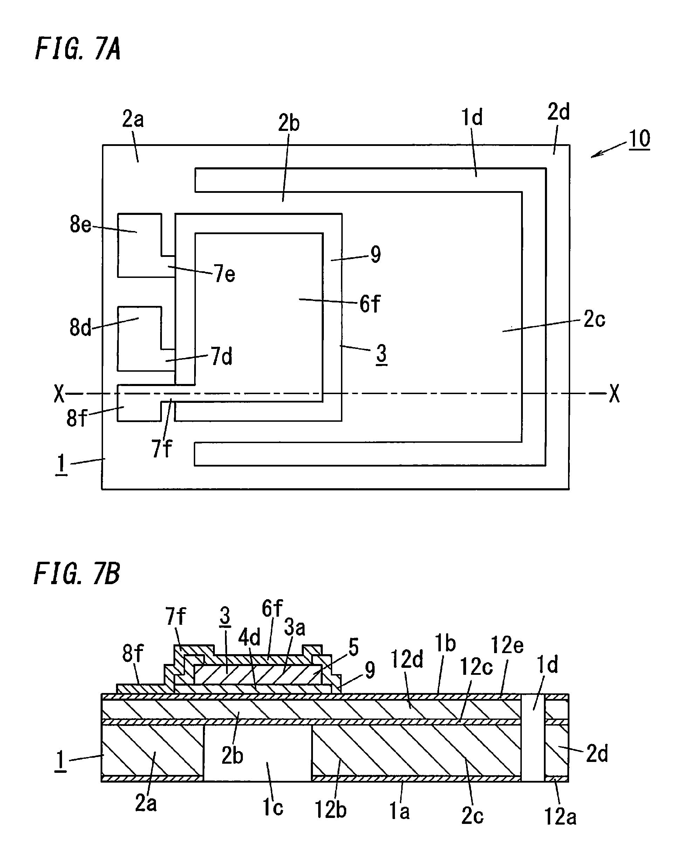

In the vibration power generating element 10 shown in Figs. 1A and 1B, the first and second piezoelectric converters 3a, 3b are formed by using the shared lower electrode 4, the shared piezoelectric layer 5, and the spatially-separated upper electrodes 6a, 6b. Meanwhile, another vibration power generating element 10 according to the present embodiment is shown in Figs. 7A and 7B. In this element 10, a first piezoelectric converter 3a and a second piezoelectric converter (not shown) may be formed by using individual lower electrodes, a shared piezoelectric layer 5, and a single shared upper electrode 6f. In this case, a lower electrode 4d of the first piezoelectric converter 3a is separated spatially from a lower electrode (not shown) of the second piezoelectric converter. Further, in the first piezoelectric converter 3a, the lower electrode 4d is electrically connected to an individual electrode 8d through a connecting part 7d. In the second piezoelectric converter, the lower electrode (not shown) separated spatially from the lower electrode 4d is electrically connected to an individual electrode 8e through a connecting part 7e. The upper electrode 6f provided to be shared by the first piezoelectric converter 3a and the second piezoelectric converter is electrically connected to a common electrode 8f through a connecting part 7f.

Therefore, the vibration power generating element 10 shown in Figs. 7A and 7B can have higher output power and be made smaller, like the vibration power generating element 10 shown in Figs. 1A and 1B.

### (Second Embodiment)

A vibration power generating element 10 of the present embodiment is substantively identical with the vibration power generating element 10 of First Embodiment. However, the element 10 of the present embodiment is different from the element 10 of First Embodiment, in using a piezoelectric layer 5a of the first piezoelectric converter 3a and a piezoelectric layer 5b of the second piezoelectric converter 3b spatially separated from the layer 5a, instead of using the single piezoelectric layer 5 shared by the first and second piezoelectric converters 3a, 3b. The constituent elements similar to those of First Embodiment are assigned with same reference numerals and the explanation thereof is herein omitted.

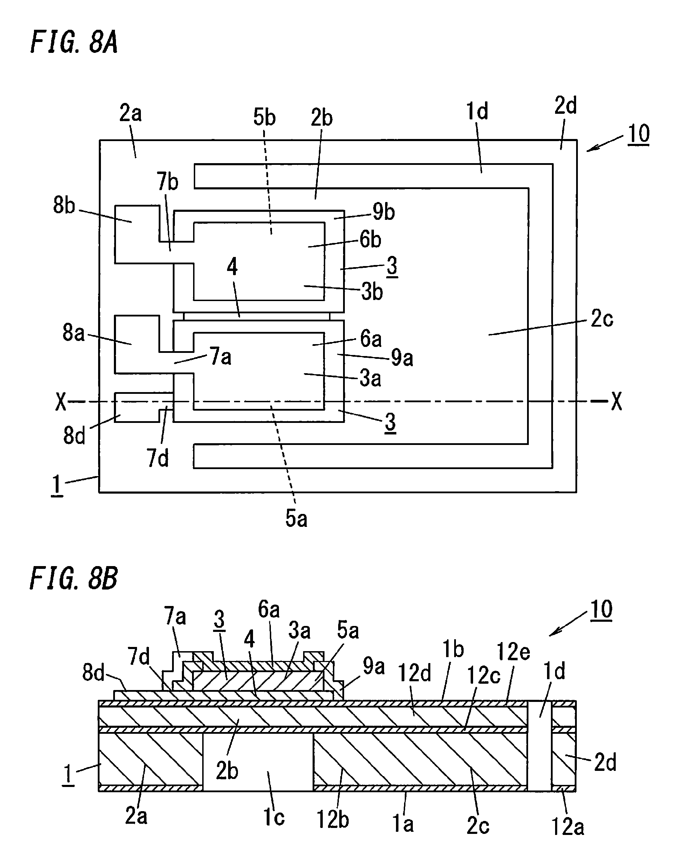

A vibration power generating element 10 of the present embodiment shown in Figs. 8A and 8B includes: a substrate 1 provided with a supporting part 2a and a cantilever 2b; and a power generation part 3, like the element 10 shown in Figs. 1A and 1B. The cantilever 2b is located inside of the supporting part 2a and is swingably supported by the supporting part 2a. The power generation part 3 is formed at the cantilever 2b located at one surface 1b side of the substrate 1 and generates AC power in response to swing of the cantilever 2b.

The power generation part 3 is provided with a first piezoelectric converter 3a and a second piezoelectric converter 3b. The first and second piezoelectric converters 3a, 3b are apposed at a region that overlaps the cantilever 2b at one surface 1b side of the substrate 1. Especially, in the vibration power generating element 10 of the present embodiment shown in Figs. 8A and 8B, the first and second piezoelectric converters 3a, 3b include a lower electrode 4 located at the cantilever 2b side. The first and second piezoelectric converters 3a, 3b further include piezoelectric layers 5a, 5b formed on a surface of the lower electrode 4, respectively. Said surface is at the opposite side of the cantilever 2b side through the lower electrode 4. The first and second piezoelectric converters 3a, 3b further include upper electrodes 6a, 6b formed on surfaces of the piezoelectric layers 5a, 5b, respectively. Said surfaces are at the opposite side of the lower electrode 4 side through the piezoelectric layers 5a, 5b.

The vibration power generating element 10 according to the present embodiment is further provided, at one surface 1b side of the substrate 1, with a common electrode 8d and individual electrodes 8a, 8b. The common electrode 8d is electrically connected to the single lower electrode 4 shared by the first and second piezoelectric converters 3a, 3b. The individual electrodes 8a, 8b are individually connected to the upper electrodes 6a, 6b of the first and second piezoelectric converters 3a, 3b, respectively.

In the vibration power generating element 10 shown in Figs. 8A and 8B, the piezoelectric layers 5a, 5b of the first and second piezoelectric converters 3a, 3b are formed on the single shared lower electrode 4.

At one surface 1b side of the substrate 1, the common electrode 8d is formed at a region corresponding to the supporting part 2a, and is electrically connected to the lower electrode 4 through a connecting part 7d. Also, at one surface 1b side of the substrate 1, the individual electrodes 8a, 8b are formed at regions corresponding to the supporting part 2a, and are electrically connected to the upper electrodes 6a, 6b, through connecting parts 7a, 7b, respectively.

Further, the vibration power generating element 10 of the present embodiment is provided with an insulation layer that is formed with a first insulation layer 9a and a second insulation layer 9b, thereby preventing a short circuit between the lower electrode 4 and the connecting parts 7a, 7b electrically connected to the upper electrodes 6a, 6b, respectively. The first insulation layer 9a is formed so as to cover a periphery of the piezoelectric layer 5a of the first piezoelectric converter 3a. The second insulation layer 9b is formed so as to cover a periphery of the piezoelectric layer 5b of the second piezoelectric converter 3b. In planar view, the first and second insulation layers 9a, 9b define areas where the upper electrodes 6a, 6b have contact with the piezoelectric layers 5a, 5b at one surface 1b side of the substrate 1, respectively. However, forming separately the first and second insulation layers 9a, 9b is not indispensable. These layers 9a, 9b may be formed integrally.

In the vibration power generating element 10 of the present embodiment, the piezoelectric layer 5a of the first piezoelectric converter 3a is separated spatially from the piezoelectric layer 5b of the second piezoelectric converter 3b. Therefore, the vibration power generating element 10 of the present embodiment can prevent parasitic capacitance from being generated between the upper electrode 6a of the first piezoelectric converter 3a and the upper electrode 6b of the second piezoelectric converter 3b and can improve the power generation efficiency, compared with the element 10 of First Embodiment shown in Figs. 1A and 1B in which the parasitic capacitance is easily generated through the share piezoelectric layer 5.

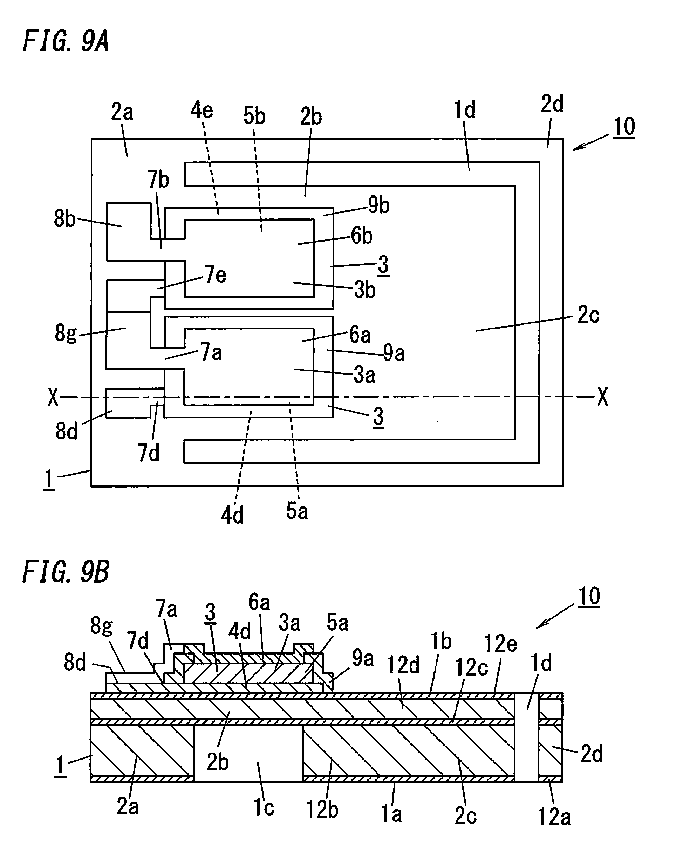

In the vibration power generating element 10, sharing of the lower electrode 4 is not indispensable. As shown in Figs. 9A and 9B, the power generation part 3 may be configured so that the first and second piezoelectric converters 3a, 3b include individual lower electrodes separated spatially from each other, respectively. That is, a lower electrode 4d of the first piezoelectric converter 3a, the piezoelectric layer 5a, and the upper electrode 6a may be separated spatially from a lower electrode 4e of the second piezoelectric converter 3b, the piezoelectric layer 5b, and the upper electrode 6b, respectively.

In the vibration power generating element 10 shown in Figs. 9A and 9B, an electrode connected to the lower electrode 4d of the first piezoelectric converter 3a via the connecting part 7d is adopted as an individual electrode 8d. Also, an electrode connected to the upper electrode 6b of the second piezoelectric converter 3b via the connecting part 7b is adopted as an individual electrode 8b. Further, an electrode connected to the upper electrode 6a of the first piezoelectric converter 3a via the connecting part 7a and an electrode connected to a lower electrode (not shown) of the second piezoelectric converter 3b via the connecting part 7e are connected in series and adopted as a common electrode 8g.

In the vibration power generating element 10 shown in Figs. 8A and 8B, or Figs. 9A and 9B, the first and second piezoelectric converters 3a, 3b are configured by using the piezoelectric layers 5a, 5b separated spatially from each other. In this case, forming the piezoelectric layers 5a, 5b with the same material is not indispensable. That is, areas, thicknesses, and materials of the piezoelectric layers 5a, 5b can be selected appropriately so that the output from the first piezoelectric converter 3a is equal to the output from the second piezoelectric converter 3b. In the vibration power generating element 10, the directions of polarization in the piezoelectric layer 5a of the first piezoelectric converter 3a can be also set so as to face a direction opposite to the directions of polarization in the piezoelectric layer 5b of the second piezoelectric converter 3b, with respect to the swing direction of the cantilever 2b. Such piezoelectric layers 5a, 5b are for example configured by performing the patterning so as to be formed into spatially-separated predetermined shapes for each of the first and second piezoelectric converters 3a, 3b, using the photolithography technique and etching technique, upon performing the patterning process for piezoelectric film in the vibration power generating element 10 of First Embodiment shown in Fig. 3C. In this case, after the piezoelectric layers 5a, 5b are separated spatially from each other and formed, the shared lower electrode 4 can be formed by etching a metal film. Or, after the piezoelectric layers 5a, 5b are separated spatially from each other and formed, the spatially-separated lower electrodes 4d, 4e may be formed by etching a metal film positioned between the first and second piezoelectric converters 3a, 3b.

Or, by using the above-mentioned transfer method, in the first and second piezoelectric converters 3a, 3b, the piezoelectric layers 5a, 5b can be also separated spatially from each other and formed on the lower electrode 4 or, on the lower electrodes 4d, 4e.

In the vibration power generating element 10 shown in Figs. 9A and 9B, electric charge induced on the lower electrodes 4d and the upper electrodes 6a has reverse polarity with respect to electric charge induced on the lower electrodes 4e and the upper electrodes 6b, upon the swing of the cantilever 2b, and the first and second piezoelectric converters 3a, 3b are connected in series. Thus, the power generation part 3 of the vibration power generating element 10 can output a high voltage equivalent to a vibration power generating element including a single piezoelectric layer having the same thickness as the sum of thicknesses of the piezoelectric layers 5a, 5b, compared with a voltage generated at the piezoelectric layer 5a of the first piezoelectric converter 3a or a voltage generated at the piezoelectric layer 5b of the second piezoelectric converter 3b.

In the vibration power generating element 10 of the present embodiment, polling treatments of the piezoelectric layers 5a, 5b using the ferroelectric thin film can be performed by applying a high electrical field between the lower electrode 4d and the upper electrode 6a and by applying a high electrical field between the lower electrode 4e and the upper electrode 6b, respectively. In this case, these high electrical fields have different polarities. Therefore, the polling treatment for each of the first and second piezoelectric converters 3a, 3b can be performed in separate process. As a result, even when there has generated a difference between the directions of polarizations in the piezoelectric layers 5a, 5b of the first and second piezoelectric converters 3a, 3b using the ferroelectric thin film, these directions of polarizations can be made so as to be parallel to one direction by the polling treatments. Also, in the vibration power generating element 10, even when there has generated a difference between the directions of polarizations in the piezoelectric layers 5a, 5b and the swing direction of the cantilever 2b, by the polling treatments, the direction of polarization in the piezoelectric layer 5a can be made so as to face a direction opposite to that in the piezoelectric layers 5b while these directions of polarizations are made so as to be parallel to the swing direction. For this reason, the vibration power generating element 10 can inhibit a decrease in the power generation efficiency caused by the difference between the directions of polarizations in the piezoelectric layers 5a, 5b and the swing direction of the cantilever 2b.

The vibration power generating element 10 shown in Figs. 9A and 9B can output electric power generated in the first piezoelectric converter 3a, using the common electrode 8g and individual electrode 8d. Similarly, the vibration power generating element 10 can output electric power generated in the second piezoelectric converter 3b, using the common electrode 8g and individual electrode 8b. Therefore, the vibration power generating element 10 of the present embodiment can supply higher output power to a load, and can be made smaller.

The vibration power generating device 20 shown in Fig. 2 can be also configured by using the vibration power generating element 10 of the present embodiment, as well as the vibration power generating element 10 of First Embodiment.

Although the present invention has been described with reference to certain preferred embodiments, numerous modifications and variations can be made by those skilled in the art without departing from the true spirit and scope of this invention, namely claims.

## Claims

1. A vibration power generating element, comprising:
a substrate provided with a supporting part and a cantilever that is swingably supported by said supporting part; and
a power generation part formed at said cantilever and generating AC power in response to swing of said cantilever,
wherein said power generation part is provided with a first piezoelectric converter and a second piezoelectric converter, said first and second piezoelectric converters being apposed at a region that overlaps said cantilever at one surface side of said substrate,
wherein each of said first and second piezoelectric converters comprises: a lower electrode located at said cantilever side; a piezoelectric layer formed on a surface of said lower electrode, said surface being at the opposite side of said cantilever side through said lower electrode; and an upper electrode formed on a surface of said piezoelectric layer, said surface being at the opposite side of said lower electrode side through said piezoelectric layer, and
wherein the vibration power generating element is further provided, at said one surface side of said substrate, with a common electrode and individual electrodes, said common electrode being electrically connected to one of said upper and lower electrodes of said first piezoelectric converter and one of said upper and lower electrodes of said second piezoelectric converter, said individual electrodes being individually connected to the other of said upper and lower electrodes of said first piezoelectric converter and the other of said upper and lower electrodes of said second piezoelectric converter, respectively.

2. The vibration power generating element according to claim 1,
wherein said upper electrode of said first piezoelectric converter and said upper electrode of said second piezoelectric converter are formed as two electrodes that are spatially separated from each other, and
wherein said lower electrode of said first piezoelectric converter and said lower electrode of said second piezoelectric converter are formed as a single shared electrode.

3. The vibration power generating element according to claim 1,
wherein said upper electrode of said first piezoelectric converter and said upper electrode of said second piezoelectric converter are formed as a single shared electrode, and
wherein said lower electrode of said first piezoelectric converter and said lower electrode of said second piezoelectric converter are formed as two electrodes that are spatially separated from each other.

4. The vibration power generating element according to claim 1,
wherein said first and second piezoelectric converters are located at symmetrical positions so that amounts of deformations generated in said first and second piezoelectric converters are equal to each other in a swing direction of said cantilever.

5. The vibration power generating element according to claim 4,
wherein said cantilever is formed so as to extend swingably from said supporting part, and
wherein said first and second piezoelectric converters are apposed in a direction perpendicular to a extending direction of said cantilever.

6. The vibration power generating element according to claim 1,
wherein said piezoelectric layer of said first piezoelectric converter is spatially separated from said piezoelectric layer of said second piezoelectric converter.

7. A vibration power generating device, comprising:
the vibration power generating element according to any one of claims 1 to 6; and
a two-phase full-wave rectifier circuit rectifying two-phase AC outputted from said common electrode and said individual electrodes in the vibration power generating element.
